# EUROPÄISCHE PATENTSCHRIFT

(11) **EP 0 759 659 B1**
(45) Veröffentlichungstag und Bekanntmachung des Hinweises auf die Patenterteilung: **30.12.1998**
(21) Anmeldenummer: 96113091.1
(22) Anmeldetag: 14.08.1996
(51) Int. Cl.: H03K 17/30, H03K 19/00, G01R 19/165

(54) **Integrierbare Komparatorschaltung mit einstellbarer Ansprechschwelle**
Integratable comparator circuit with adjustable trigger threshold
Circuit comparateur susceptible d'intégration à seuil de déclenchement ajustable

(30) Priorität: 18.08.1995 DE 19530481
(43) Veröffentlichungstag der Anmeldung: 26.02.1997
(73) Patentinhaber: SIEMENS AKTIENGESELLSCHAFT, 80333 München (DE)
(72) Erfinder: Gantioler, Josef-Matthias, Dipl.-Ing., 81925 München (DE); Heil, Holger, Dipl.-Phys., D-80805 Munchen (DE)

(56) Entgegenhaltungen:
- EP-A- 0 601 466
- EP-A- 0 651 506
- WO-A-86/02492
- DE-C- 4 138 860
- US-A- 4 646 427
- US-A- 4 709 172
- US-A- 4 820 657
- US-A- 4 874 711

## Beschreibung

Die Erfindung betrifft eine integrierte Komparatorschaltung mit den Merkmalen:
a) Einer Reihenschaltung mit einem ersten und einem zweiten MOSFET, die zwischen einem ersten Anschluß für die Betriebsspannung und einem ersten Eingangsanschluß angeschlossen ist,
b) einer Inverterstufe mit einem dritten und vierten MOSFET, die zwischen dem ersten Anschluß und einem zweiten Anschluß für die Betriebsspannung angeschlossen ist,
c) der Knoten zwischen erstem und zweitem MOSFET ist mit dem Gateanschluß des vierten MOSFET verbunden,
d) ein zweiter Eingangsanschluß ist mit dem zweiten Anschluß für die Betriebsspannung verbunden,
e) die Übertragungskennlinie des zweiten MOSFET ist steiler als die des vierten MOSFET.

Eine solche integrierte Komparatorschaltungen sind z. B. in der DE 4138860 und der EP 0651506 beschrieben worden. Sie unterscheiden sich hauptsächlich dadurch, daß in der ersten ausschließlich Enhancement-MOSFET beider Kanaltypen verwendet werden, während in der zweiten Depletion- und Enhancement-MOSFET ein- und desselben Kanaltyps zur Anwendung kommen.

Der Schaltpunkt der beschriebenen Komparatorschaltungen wird durch die Eigenschaften der MOSFET bestimmt. Da diese Eigenschaften durch den Herstellungsprozeß bestimmt sind, können sie von Wafer zu Wafer innerhalb gewisser Bandbreiten unterschiedlich sein. Damit ist auch die Komparatorschwelle unterschiedlich groß.

Der Erfindung liegt die Aufgabe zugrunde, die integrierte Komparatorschaltung so weiterzubilden, daß eine Einstellung der Schwelle nachträglich am fertigen Bauelement korrigiert werden kann.

Diese Aufgabe wird gelost durch die Merkmale:
f) Dem vierten MOSFET ist die Reihenschaltung mit einem fünften MOSFET und einer sourceseitig angeschlossenen, in Sperrichtung gepolten Zenerdiode parallel geschaltet,
g) die Gateanschlüsse von viertem und fünftem MOSFET sind miteinander verbunden,
h) der Katodenanschluß der Zenerdiode ist mit einem weiteren Anschluß verbunden, an den ein Impuls anlegbar ist,
h) der in Rückwärtsrichtung fließende Strom der Zenerdiode ist durch die Energie des Impulses einstellbar.

Weiterbildungen der Erfindung sind Gegenstand der Unteransprüche.

Die Erfindung wird anhand zweier Ausführungsbeispiele in Verbindung mit den Figuren 1 bis 3 näher erläutert. Es zeigen
- Figur 1: ein erstes Ausführungsbeispiel der Erfindung,
- Figur 2: ein zweites Ausführungsbeispiel und
- Figur 3: ein Ausführungsbeispiel des mit der Zenerdiode in Reihe geschalteten fünften MOSFET.

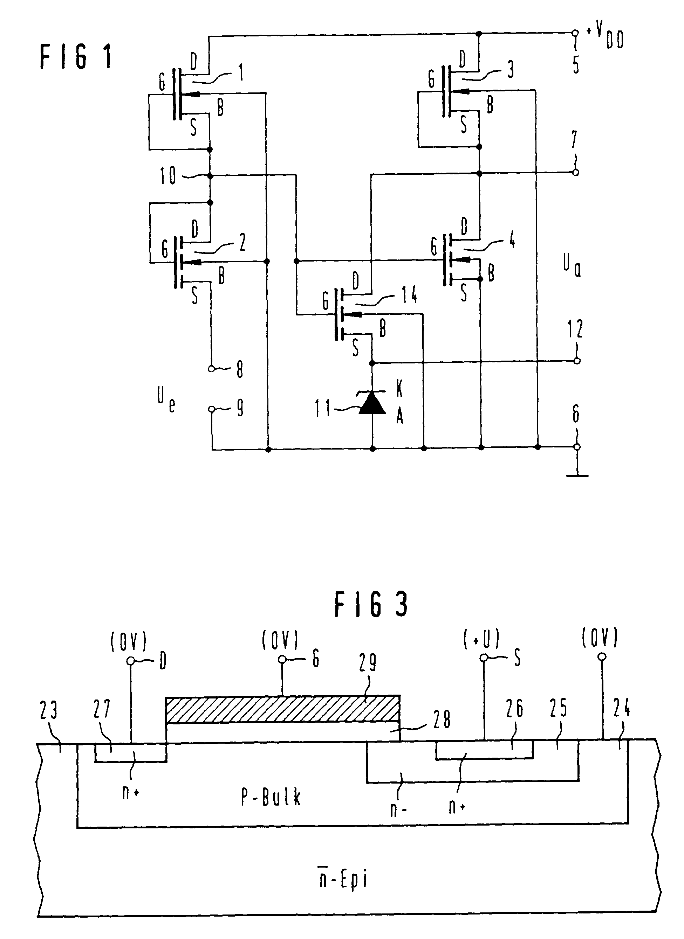

Die integrierte Komparatorschaltung nach Figur 1 enthält eine Reihenschaltung mit einem ersten MOSFET 1 und einem zweiten MOSFET 2. Der MOSFET 1 ist drainseitig mit einem ersten Anschluß 5 für eine Versorgungsspannung verbunden. Der Sourceanschluß des MOSFET 2 ist mit einem ersten Eingangsanschluß 8 verbunden. Ein zweiter Eingangsanschluß 9 liegt über einen zweiten Anschluß 6 für die Versorgungsspannung auf festem Potential, z. B. auf Masse. An die Anschlüsse 5, 6 ist ein Inverter mit einem dritten MOSFET 3 und einem vierten MOSFET 4 angeschlossen. Der MOSFET 3 liegt dabei drainseitig am Anschluß 5, der MOSFET 4 sourceseitig am Anschluß 6. Der Knoten zwischen den MOSFET 3 und 4 ist mit einem Ausgangsanschluß 7 verbunden.

Dem MOSFET 4 ist die Reihenschaltung mit einem fünften MOSFET 14 und einer Zenerdiode 11 parallel geschaltet. Dabei sind Drainanschlüsse beider MOSFET miteinander verbunden, während der Sourceanschluß von 14 mit dem Katodenanschluß der Zenerdiode 11 verbunden ist. Der Sourceanschluß des MOSFET 14 bzw. der Katodenanschluß der Zenerdiode 11 ist mit einem frei zugänglichen Anschluß 12 verbunden, dessen Zweck weiter unten erläutert wird.

Die Gateanschlüsse der MOSFET 1 und 3 sind jeweils mit ihren Sourceanschlüssen verbunden, der Gateanschluß des MOSFET 2 ist mit seinem Drainanschluß verbunden. Die Gateanschlüsse könnten jedoch auch jeweils auf festen Potentialen liegen. Außerdem haben die MOSFET Bulkanschlüsse B, die bei den MOSFET 1 bis 3 mit Masse verbunden sind, während er beim MOSFET 4 mit dem Sourceanschluß verbunden ist. Die Verbindung der Bulkanschlüsse mit Masse bei den MOSFET 1 bis 3 ist dann notwendig, wenn sie in sogenannter selbstisolierender Technik hergestellt sind. Werden sie in einer anderen Technologie, z. B. mit dielektrischer Isolation hergestellt, kann der Bulkanschluße jedes MOSFET mit seinem Sourceanschluß verbunden sein.

Zur Erläuterung der Wirkungsweise sei zunächst angenommen, daß die Eingangsspannung Uₑ an den Anschlüssen 8, 9 unterhalb der Ansprechschwelle des Komparators liegt. Es fließt dann ein Strom vom Anschluß 5 über die MOSFET 1 und 2 und durch die die Eingangsspannung liefernde Steuerstufe zum Anschluß 6. Dabei stellt sich am Knoten 10 zwischen den MOSFET 1 und 2 eine Spannung ein, die den MOSFET 4 gesperrt hält. Der MOSFET 3 hat einen niedrigen Drain- Sourcewiderstand, da sein Arbeitspunkt im steilen Teil der I_{D}/U_{DS}-Kennlinie liegt. Am Ausgang 7 erscheint daher eine hohe Spannung, die etwa der Spannung V_{DD} entspricht.

Wird an die Eingangsanschlüsse 8, 9 eine höhere Spannung angelegt, so erhöht sich die Spannung am Knoten 10 entsprechend dem Spannungsteilerverhältnis zwischen den MOSFET 1 und 2. Übersteigt die Spannung am Knoten 10 die Einsatzspannung des MOSFET 4, so wird dieser leitend gesteuert und die Spannung am Ausgang 7 sinkt ab. Der Strom wird durch den MOSFET 3 begrenzt, der im vorliegenden Fall als Diode geschaltet ist. Für den Fall, daß sein Bulkanschluß B mit dem Sourceanschluß S verbunden ist, wirkt er als Stromquelle. In beiden Fällen fließt ein Strom durch den Inverter, der durch den Schnittpunkt ihrer I_{D}/U_{DS}-Kennlinien bestimmt ist. Die Spannung Uₐ zwischen den Anschlüssen 7 und 6 wird z. B. einem Schmitt-Trigger zugeführt, dessen Ausgangssignalpegel so gewählt sind, daß sie logisch "0" oder logisch "1" entsprechen.

Um eine definierte Ansprechschwelle der Komparatorschaltung einzustellen, wird die Übertragungskennlinie I_{D}/U_{GS} des MOSFET 4 flacher eingestellt als die des Transistors 2. Dies kann z. B. durch ein unterschiedliches Verhältnis von Kanallänge zu Kanalbreite erreicht werden. Die Übertragungskennlinien der MOSFET 1 und 3 können, müssen jedoch nicht gleich sein. Da die Übertragungskennlinien wie auch andere Parameter durch Fertigungsschwankungen von Exemplar zu Exemplar streuen können, wird die Übertragungskennlinie des MOSFET 4 nach Fertigstellung des Komparators extern auf den gewünschten Wert eingestellt. Dies geschieht dadurch, daß an den Anschluß 12 ein Stromimpuls angelegt wird, der an der Zenerdiode eine Spannung erzeugt, die größer als die Zenerspannung ist. Die Zenerdiode 11 ist so aufgebaut, daß durch den Stromimpuls ein Legierungskanal zwischen Katodenanschluß und Anodenanschluß entsteht, der einen definierten ohmschen Widerstand bildet. Die Höhe des Widerstands kann durch die Energie des Impulses bestimmt werden. Eine solche Zenerdiode zur Einstellung eines definierten Widerstandes ist an sich bekannt und z. B. in der PCT-Anmeldung WO 86/02492 beschrieben worden.

Über den durch die Zenerdiode 11 gebildeten definierten Widerstand ist nun der MOSFET 14 dem MOSFET 4 parallel geschaltet. Da beide Gateanschlüsse miteinander verbunden sind, fließt nun bezogen auf die gleiche Spannung am Knoten 10 ein höherer Strom. Die Übertragungskennlinie I_{D}/U_{GS} der beschriebenen Parallelschaltung ist nun steiler als die des MOSFET 4 alleine. Das heißt, daß die Ansprechschwelle des Komparators zu niedrigeren Werten der Eingangsspannung Uₑ hin verschoben ist.

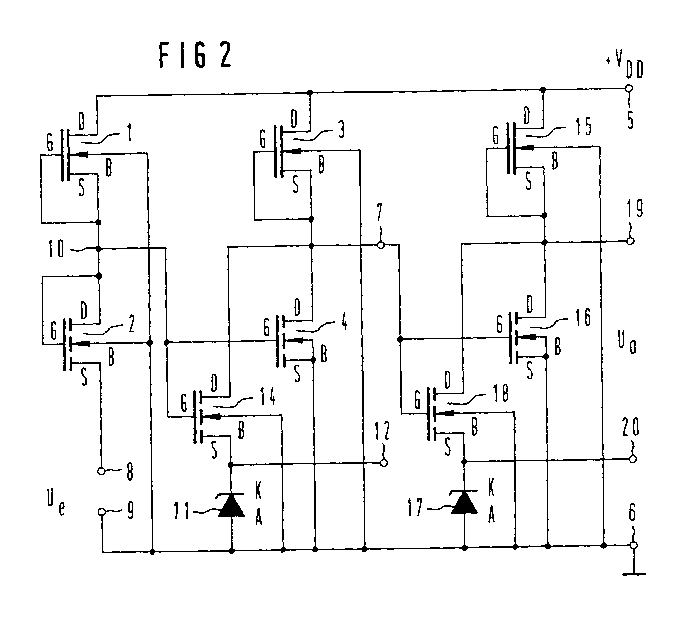

In Figur 2 ist eine gegenüber der Komparatorschaltung nach Figur 1 erweiterte Komparatorschaltung dargestellt. Diese unterscheidet sich von der Schaltung nach Figur 1 durch einen weiteren Inverter mit den MOSFET 15 und 16. Der Drainanschluß des MOSFET 15 ist mit dem ersten Versorgungsspannungsanschluß 5 verbunden, der Sourceanschluß des MOSFET 16 mit dem zweiten Versorgungsspannungsanschluß 6. Der Knoten zwischen dem Sourceanschluß von 15 und dem Drainanschluß von 16 ist mit einem Ausgangsanschluß 19 verbunden. Dem MOSFET 16 ist analog zur Schaltung nach Figur 1 die Reihenschaltung aus einem MOSFET 18 und einer in Sperrichtung gepolten Zenerdiode 17 parallel geschaltet. Der Sourceanschluß des MOSFET 18 bzw. der Katodenanschluß der Zenerdiode 17 ist mit einem frei zugänglichen Anschluß 20 verbunden. Die Gateanschlüsse der MOSFET 16, 18 sind elektrisch mit dem Ausgang 7 verbunden.

Zur Erläuterung der Wirkungsweise sei wieder angenommen, daß die Eingangsspannung Uₑ zunächst unterhalb der Ansprechschwelle des Komparators liege. Dann liegt der Ausgang 7 wie in Verbindung mit Figur 1 beschrieben auf einem Potential, das etwa der Betriebsspannung V_{DD} entspricht. Damit ist der MOSFET 16 leitend gesteuert und die Ausgangsspannung Uₐ am Ausgang 19 ist niedrig (Pegel L). Steigt die Eingangsspannung Uₑ, so steigt das Potential am Knoten 10 an, bis die Einsatzspannung des MOSFET 4 erreicht wird. Damit sinkt die Spannung am Ausgang 7 und der MOSFET 16 wird gesperrt, wenn seine Einsatzspannung unterschritten wird. Damit steigt die Ausgangsspannung Uₐ am Ausgang 19 auf einen Wert, der etwa der Versorgungsspannung V_{DD} entspricht (Pegel H).

Durch eine definierte Energiezufuhr über den Anschluß 20 kann, wie schon in Verbindung mit Figur 1 für die Diode 11 beschrieben, die Diode 17 in einen definierten Widerstand verwandelt werden. Damit wird der MOSFET 18 über einen definierten Widerstand dem MOSFET 16 parallel geschaltet. Das bedeutet, daß nun bei entsprechend niedriger Spannung am Ausgang 7 die Spannung am Ausgang 19 auf den Pegel L absinkt. Dieser niedrigeren Spannung am Ausgang 7 entspricht einem höheren Spannungswert am Knoten 10 und am Eingang 8, 9. Das heißt, daß durch Parallelschalten der MOSFET 16, 18 die Ansprechschwelle des Komparators erhöht wird.

Ist die Ansprechschwelle der Schaltung nach Figur 2 zu hoch, so wird sie wie in Verbindung mit Figur 1 beschrieben, durch Parallelschalten der MOSFET 14 und 4 herabgesetzt. Die Zenerdiode 17 bleibt gesperrt, der MOSFET 18 wird 16 nicht parallelgeschaltet.

Dadurch, daß der Katodenanschluß der Zenerdiode 11, 17 mit einem positiven Impuls belastet wird, wird der pn-Übergang zwischen der Sourcezone des MOSFET 14 bzw. 18 und seiner Bulkzone in Sperrichtung vorgespannt. Da beide Zonen normalerweise hoch dotiert sind, könnte dieser pn-Übergang zerstört werden. Es ist daher notwendig, die Sourcezone der MOSFET 14, 18 in eine niedriger dotierte Zone einzubetten, die bis unter die Gateelektrode reicht. In Figur 3 ist dargestellt, daß eine p-leitende Bulkzone 24 in ein schwach n-dotiertes Epi-Substrat eingebettet ist. In die Bulkzone 24 ist eine schwach n-dotierte Zone 25 eingebettet, in die Zone 25 eine stark n-dotierte Sourcezone 26. In die Bulkzone ist außerdem eine stark n-dotierte Drainzone 27 eingebettet. Auf dem Halbleiterkörper liegt eine Gateoxidschicht 28, auf der eine Gateelektrode 29 angeordnet ist. Das Gateoxid und die Gateelektrode reichen von der Drainzone 27 bis zur schwach n-dotierten Zone 25. Der leitende Kanal kann sich dann bei positiveren Gatespannung zwischen der schwach n-dotierten Zone 25 und der Drainzone 27 ausbilden. Die Zone 25 kann dabei von der Gateelektrode 29 überlappt werden.

## Patentansprüche

1. Integrierte Komparatorschaltung mit den Merkmalen:
a) Einer Reihenschaltung mit einem ersten und einem zweiten MOSFET, (1, 2) die zwischen einem ersten Anschluß für die Betriebsspannung (5) und einem ersten Eingangsanschluß (8) angeschlossen ist,
b) einer Inverterstufe mit einem dritten und vierten MOSFET, (3,4) die zwischen dem ersten Anschluß (5) und einem zweiten Anschluß (6) für die Betriebsspannung angeschlossen ist,
c) der Knoten (10) zwischen erstem und zweitem MOSFET ist mit dem Gateanschluß des vierten MOSFET (4) verbunden,
d) ein zweiter Eingangsanschluß (9) ist mit dem zweiten Anschluß für die Betriebsspannung (6) verbunden,
e) die Übertragungskennlinie des zweiten MOSFET (2) ist steiler als die des vierten MOSFET (4),
**gekennzeichnet durch** die Merkmale:
f) dem vierten MOSFET (4) ist die Reihenschaltung mit einem fünften MOSFET (14) und einer sourceseitig angeschlossenen, in Sperrichtung gepolten Zenerdiode (11) parallelgeschaltet,
g) die Gateanschlüsse (G) von viertem und fünftem MOSFET sind miteinander verbunden,
h) der Katodenanschluß der Zenerdiode (11) ist mit einem weiteren Anschluß (12) verbunden, an dem ein Impuls anlegbar ist,
i) der in Rückwärtsrichtung fließende Strom der Zenerdiode ist durch die Energie des Impulses einstellbar.

2. Integrierte Komparatorschaltung nach Anspruch 1,
**dadurch gekennzeichnet**,
daß der Inverterstufe (3, 4) eine weitere Inverterstufe mit einem achten (15) und sechsten MOSFET (16) parallel geschaltet ist und daß der Gateanschluß des sechsten MOSFET (16) mit dem Knoten zwischen drittem (3) und viertem (4) MOSFET verbunden ist.

3. Integrierte Komparatorschaltung nach Anspruch 2,
**dadurch gekennzeichnet,**
daß dem sechsten MOSFET (16) die Reihenschaltung aus einem siebten MOSFET (18) und einer sourceseitig angeschlossenen, in Sperrichtung gepolten Zenerdiode (17) parallel geschaltet ist, daß der Katodenanschluß der Zenerdiode mit einem weiteren Anschluß (20) verbunden ist, an dem ein Impuls anlegbar ist und daß der in Rückwärtsrichtung fließende Strom der Zenerdiode durch einen Impuls einstellbar ist.

4. Integrierte Komparatorschaltung nach einem der Ansprüche 1 bis 3,
**dadurch gekennzeichnet,**
daß der fünfte (14) bzw. siebte MOSFET (18) ein Lateral-MOSFET ist und daß seine Sourcezone (26) in eine Zone (25) eingebettet ist, die den gleichen Leitungstyp hat, aber schwächer dotiert ist als diese und daß sich die Zone (25) bis unter die Gateelektrode (29) erstreckt.

## Claims

1. Integrated comparator circuit having the features:
a) a series circuit with a first and a second MOSFET (-1, 2), which is connected between a first terminal for the operating voltage (5) and a first input terminal (9),
b) an invertor stage with a third and fourth MOSFET (3, 4), which is connected between the first terminal (5) and a second terminal (6) for the operating voltage,
c) the node (10) between the first and second MOSFET is connected to the gate terminal of the fourth MOSFET (4),
d) a second input terminal (9) is connected to the second terminal for the operating voltage (6),
e) the transfer characteristic of the second MOSFET (2) is steeper than that of the fourth MOSFET (4),
characterized by the features:
f) the fourth MOSFET (4) is connected in parallel with the series circuit with a fifth MOSFET (14) and a Zener diode (11) which is connected on the source side and polarized in the reverse direction,
g) the gate terminals (G) of the fourth and fifth MOSFET are interconnected,
h) the cathode terminal of the Zener diode (11) is connected to a further terminal (12) to which a pulse can be applied, and
i) the current of the Zener diode flowing in the reverse direction can be adjusted by the energy of the pulse

2. Integrated comparator circuit according to Claim 1, characterized in that the invertor stage (3, 4) is connected in parallel with a further invertor stage with an eighth (15) and sixth MOSFET (16), and in that the gate terminal of the sixth MOSFET (16) is connected to the node between the third (3) and fourth (4) MOSFET.

3. Integrated comparator circuit according to Claim 2, characterized in that the sixth MOSFET (16) is connected in parallel with the series circuit of a seventh MOSFET (18) and Zener diode (17), which is connected on the source side and polarized in the reverse direction, in that the cathode terminal of the Zener diode is connected to a further terminal (20) to which a pulse can be applied, and in that the current of the Zener diode flowing in the reverse direction can be adjusted by a pulse.

4. Integrated comparator circuit according to one of Claims 1 to 3, characterized in that the fifth (14) or seventh MOSFET (18) is a lateral MOSFET, and in that its source region (26) is embedded in a zone (25) which is of the same conductivity type, but is more weakly doped than said region, and in that the zone (25) extends up to below the gate electrode (29).

## Revendications

1. Circuit comparateur intégré comportant les caractéristiques :
a) un circuit série qui comprend un premier et un deuxième MOSFET et qui raccordé entre une première borne pour la tension de service et une première borne d'entrée,
b) un étage inverseur qui comporte un troisième et un quatrième MOSFET et qui est raccordé entre la première et une deuxième borne pour la tension de service,
c) le point nodal entre le premier et le deuxième MOSFET est relié à la borne de grille du quatrième MOSFET,
d) une deuxième borne d'entrée est reliée à la deuxième borne pour la tension de service,
e) la courbe caractéristique de transfert du deuxième MOSFET est plus pentue que celle du quatrième MOSFET,
caractérisé par les caractéristiques :
f) le circuit série comportant un cinquième MOSFET (14) et une diode (11) Zener raccordée côté source et polarisée dans le sens non passant est branché en parallèle avec la quatrième MOSFET (4),
g) les bornes (G) de grille du quatrième et du cinquième MOSFET sont reliées l'une à l'autre,
h) la borne de cathode de la diode (11) Zener est reliée à une borne (12) supplémentaire à laquelle une impulsion peut être appliquée,
i) le courant de la diode Zener passant en sens inverse peut être réglé par l'énergie de l'impulsion.

2. Circuit comparateur intégré suivant la revendication 1, caractérisé en ce que un étage inverseur supplémentaire comportant un huitième MOSFET (15) et un sixième MOSFET (16) est branché en parallèle avec l'étage (3, 4) inverseur et en ce que la borne de grille du sixième MOSFET (16) est reliée au point nodal entre le troisième MOSFET (3) et le quatrième MOSFET (4).

3. Circuit comparateur intégré suivant la revendication 2, caractérisé en ce que le circuit série constitué d'un septième MOSFET (18) et d'une diode (17) Zener raccordé côté source et polarisé dans le sens non passant, est branché en parallèle avec le sixième MOSFET (16), en ce que la borne de cathode de la diode Zener est reliée à une borne (20) supplémentaire à laquelle une impulsion peut être appliquée et en ce que le courant de la diode Zener passant en sens inverse peut être réglé par une impulsion.

4. Circuit comparateur intégré suivant l'une des revendications 1 à 3, caractérisé en ce que le cinquième MOSFET (14) et le septième MOSFET (18) sont des MOSFET latéraux et en ce que leurs zones (26) de source sont enrobées dans une zone (25) qui a le même type de conductivité, mais qui sont à dopage plus faible que celui de la zone de source et en ce que la zone (25) s'étend jusqu'au dessous de l'électrode (29) de grille.
